# EUROPEAN PATENT APPLICATION

(11) **EP 3 865 842 A1**
(43) Date of publication of application: **18.08.2021**
(21) Application number: 21151136.5
(22) Date of filing: 12.01.2021
(51) Int. Cl.: G01L 5/24, F03D 17/00

(54) **FASTENER WITH SENSING CIRCUIT, SENSING CIRCUIT, AND WIND TURBINE DRIVE DEVICE**

(30) Priority: 13.02.2020 JP 2020022644
(71) Applicant: Nabtesco Corporation, Tokyo 102-0093 (JP)
(72) Inventor: KODAMA, Haruo, Chiyoda-ku, Tokyo 102-0093 (JP); ASAKAWA, Yuichi, Chiyoda-ku, Tokyo 102-0093 (JP)
(74) Representative: Grünecker Patent- und Rechtsanwälte PartG mbB

(57) **Abstract**

A fastener (130) with a sensing circuit (166) according to an aspect of the present invention includes a head portion (132), a columnar portion (134) formed integrally with the head portion (132), and a threaded portion (136) formed integrally with the columnar portion (134), the fastener (130) including: a sensing circuit (166) having a bridge circuit (300), the bridge circuit (300) including: a resistance member (220) attached to the columnar portion (134); and a circuit portion mounted to the head portion (132) and connected to the resistance member (220), the bridge circuit (300) being configured to sense electrical resistance of the resistance member (220).

## Description

### TECHNICAL FIELD

The present invention relates to a fastener with a sensing circuit, a sensing circuit, and a wind turbine drive device.

### BACKGROUND

Some of conventionally known wind power generation devices have a yaw control function for adjusting the orientation of a blade in accordance with the wind direction. An example of such wind power generation devices is disclosed in Patent Literature 1. The wind power generation device disclosed in Patent Literature 1 is installed on the land or on the ocean, and it includes a tower serving as a support post for a power generator, a nacelle disposed on top of the tower and containing the power generator, and a rotor disposed on one end of the nacelle and formed of a hub and a blade for converting the received wind force into rotation energy. This wind power generation device includes a yaw drive unit disposed in a connection portion between the tower and the nacelle and configured to control the positions of the nacelle and the rotor relative to the tower. Patent Literature 1 discloses that the wind power generation device provided has a high availability, which is achieved by the yaw drive unit that disconnects transmission of a yaw drive force to minimize an impact of yaw control failure due to malfunctions of the yaw drive device.

In the above wind power generation device, when fixation occurs between a yaw bearing gear and a pinion gear due to gear deformation caused by strong winds such as those of a typhoon, the transmission of the yaw drive force from the pinion gear to the yaw bearing gear is disconnected. In the above wind power generation device, the fixation between the yaw bearing gear and the pinion gear is detected when the electric current in the yaw inverter exceeds a rated current or a predetermined interlock value.

### RELEVANT REFERENCES

### LIST OF RELEVANT PATENT LITERATURE

Patent Literature 1: Japanese Patent Application Publication No. 2015-140777

### SUMMARY

In the above wind power generation device, the electric current in the yaw inverter is sensed to detect the fixation (the load) between the yaw bearing gear and the pinion gear. However, since the current in the yaw inverter is sensed, the above wind power generation device has a drawback that the load cannot be detected while the operation of the yaw inverter is stopped.

The present invention addresses the above drawback, and one object thereof is to provide a fastener with a sensing circuit, a sensing circuit, and a wind turbine drive device that are capable of detecting the load while the drive device is stopped.

To achieve the above object, a fastener with a sensing circuit according to an aspect of the present invention includes a head portion, a columnar portion formed integrally with the head portion, and a threaded portion formed integrally with the columnar portion, the fastener comprising a sensing circuit having a bridge circuit, the bridge circuit including: a resistance member attached to the columnar portion; and a circuit portion mounted to the head portion and connected to the resistance member, the bridge circuit being configured to sense electrical resistance of the resistance member. With this fastener with a sensing circuit, the electrical resistance of the resistance member is sensed without using electric current in the drive device, and therefore, a load can be sensed while the drive device is stopped.

In the fastener with a sensing circuit described above, the electrical resistance is sensed as a value based on a strain in the columnar portion. With this fastener with a sensing circuit, the electrical resistance is sensed as a value based on the strain in the columnar portion, and therefore, a load can be sensed while the drive device is stopped.

In the fastener with a sensing circuit described above, the sensing circuit includes an amplifier mounted to the head portion and configured to amplify a signal output from the bridge circuit. With this fastener with a sensing circuit, the signal related to electrical resistance can be amplified.

In the fastener with a sensing circuit described above, the sensing circuit includes a converter circuit mounted to the head portion and configured to convert the signal amplified by the amplifier. With this fastener with a sensing circuit, the amplified signal related to electrical resistance can be converted.

In the fastener with a sensing circuit described above, the sensing circuit includes a communication unit mounted to the head portion and configured to output the signal converted by the converter circuit. With this fastener with a sensing circuit, the amplified and converted signal related to electrical resistance can be output.

In the fastener with a sensing circuit described above, the sensing circuit includes a connector portion mounted to the head portion and configured to be removably connected with an external cable. With this fastener with a sensing circuit, an external cable can be connected for outputting the amplified and converted signal related to electrical resistance.

To achieve the above object, a sensing circuit according to an aspect of the present invention comprises a bridge circuit, the bridge circuit including: a resistance member attached to a columnar portion of a fastener, the fastener including a head portion, the columnar portion formed integrally with the head portion, and a threaded portion formed integrally with the columnar portion; and a circuit portion mounted to the head portion of the fastener and connected to the resistance member, the bridge circuit being configured to sense electrical resistance of the resistance member. With this sensing circuit, the electrical resistance of the resistance member is sensed without using electric current in the drive device, and therefore, a load can be sensed while the drive device is stopped.

To achieve the above object, a wind turbine drive device according to an aspect of the present invention comprises: a brake unit for generating a braking force for stopping a second structure relative to a first structure, the second structure being movable relative to the first structure; and a fastener fixing the wind turbine drive device including the brake unit to the second structure. The fastener includes a head portion, a columnar portion formed integrally with the head portion, a threaded portion formed integrally with the columnar portion, and a sensing circuit having a bridge circuit, the bridge circuit including: a resistance member attached to the columnar portion; and a circuit portion mounted to the head portion and connected to the resistance member, the bridge circuit being configured to sense electrical resistance of the resistance member. With this wind turbine drive device, the electrical resistance of the resistance member is sensed without using electric current in the drive device, and therefore, a load can be sensed while the drive device is stopped.

To achieve the above object, a fastener with a sensing circuit according to an aspect of the present invention includes a fastener and a sensing circuit. The fastener includes: a head portion including an upper surface and a lower surface, both surfaces being planar, and a hole extending from the upper surface to the lower surface; a columnar portion including a side surface integrated with the lower surface and positioned to contact with an opening of the hole in a radial direction of the head portion, the columnar portion having a first diameter smaller than a diameter of the head portion; and a threaded portion integrated with the columnar portion and having a threaded surface. The sensing circuit includes: a bridge circuit, an amplifier, a converter circuit, a communication unit, and a connector portion. The bridge circuit includes: a resistance member attached to the columnar portion; and a circuit portion mounted to the head portion and connected to the resistance member, the bridge circuit being configured to sense electrical resistance of the resistance member. The amplifier is mounted to the head portion and configured to amplify a signal output from the bridge circuit. The converter circuit is mounted to the head portion and configured to convert the signal amplified by the amplifier. The communication unit is configured to output the signal converted by the converter circuit. The connector portion is mounted to the head portion and configured to be removably connected with an external cable. With this fastener with a sensing circuit, the electrical resistance of the resistance member is sensed without using electric current in the drive device, and therefore, a load can be sensed while the drive device is stopped.

To achieve the above object, a wind turbine drive device according to an aspect of the present invention comprises: a brake unit for generating a braking force for stopping a second structure relative to a first structure, the second structure being movable relative to the first structure; a drive unit for generating a drive force for moving the second structure relative to the first structure; a fastener; and a sensing circuit. The fastener includes: a head portion including an upper surface and a lower surface, both surfaces being planar, and a hole extending from the upper surface to the lower surface; a columnar portion including a side surface integrated with the lower surface and positioned to contact with an opening of the hole in a radial direction of the head portion, the columnar portion having a first diameter smaller than a diameter of the head portion; and a threaded portion integrated with the columnar portion and having a threaded surface. The fastener fixes the wind turbine drive device to the second structure, the wind turbine drive device including the brake unit and the drive unit. The sensing circuit includes: a bridge circuit, an amplifier, a converter circuit, a communication unit, and a connector portion. The bridge circuit includes: a resistance member attached to the columnar portion; and a circuit portion mounted to the head portion and connected to the resistance member, the bridge circuit being configured to sense electrical resistance of the resistance member. The amplifier is mounted to the head portion and configured to amplify a signal output from the bridge circuit. The converter circuit is mounted to the head portion and configured to convert the signal amplified by the amplifier. The communication unit is configured to output the signal converted by the converter circuit. The connector portion is mounted to the head portion and configured to be removably connected with an external cable. With this wind turbine drive device, the electrical resistance of the resistance member is sensed without using electric current in the drive device, and therefore, a load can be sensed while the drive device is stopped.

### ADVANTAGEOUS EFFECTS

According to one aspect of the present invention, the load can be detected while the drive device is stopped.

### BRIEF DESCRIPTION OF THE DRAWINGS

Fig. 1 is a perspective view showing an example of a wind power generation device according to an embodiment of the present invention.
Fig. 2 is a top view showing a relationship between the tower and the yaw drive devices according to the embodiment.
Fig. 3 shows an example of the yaw drive device according to the embodiment.
Fig. 4 is a top view showing an example of the yaw drive device according to the embodiment.
Fig. 5 is a perspective view showing an example of a fastening bolt and a strain sensor according to the embodiment.
Fig. 6 shows an example of internal configuration of the strain sensor according to the embodiment.
Fig. 7 shows an example of circuit configuration of the strain sensor according to the embodiment.
Fig. 8 is a block diagram showing an example of functionality of the wind power generation device according to the embodiment.

### DESCRIPTION OF THE EMBODIMENTS

With reference to the drawings, the following describes a fastener with a sensing circuit, a sensing circuit, and a wind turbine drive device according to the embodiment.

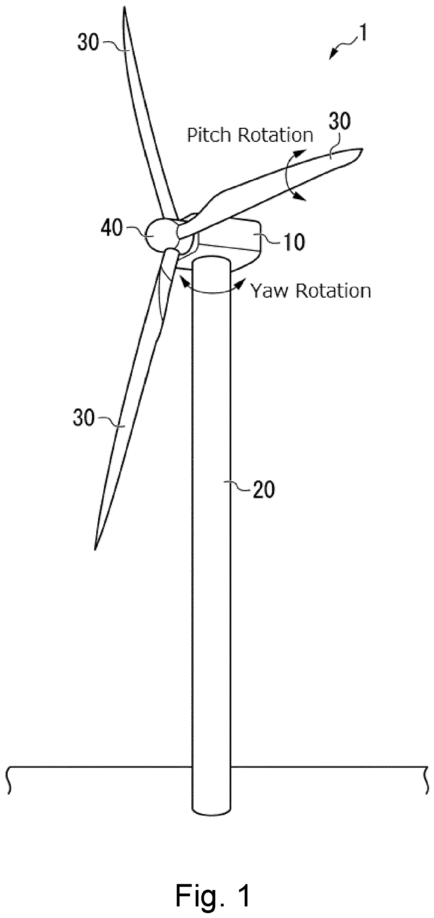

Fig. 1 is a perspective view showing an example of a wind power generation device according to an embodiment of the present invention. The wind power generation device 1 includes, for example, a nacelle 10, a tower 20, a blade 30, and a hub 40. The tower 20 and the nacelle 10 are examples of two structures included in the wind power generation device 1. The tower 20 and the nacelle 10 move relative to each other by a force from drive devices (yaw drive devices 100). The tower 20 is an example of a first structure. The first structure is a part of the wind power generation device 1 installed fixedly. The nacelle 10 is an example of a second structure. The second structure moves relative to the first structure by the drive force from the yaw drive devices 100 and stops relative to the first structure by the braking force from the yaw drive devices 100.

The nacelle 10 is mounted on the top end (the end in the Z direction) of the tower 20. The blade 30 is mounted to the nacelle 10 via the hub 40. The nacelle 10 turns to adjust the orientation of the blade 30 and the hub 40 in the yaw direction. The nacelle 10 includes yaw drive mechanisms for generating a yaw drive force for rotating the nacelle 10 in the yaw direction. The yaw drive devices are an example of drive devices and wind turbine drive devices. The drive devices and the wind turbine drive devices generate a force for rotating the orientation of the blade 30 and the hub 40 (the orientation of a wind turbine) in accordance with the wind direction. The yaw drive devices rotate the orientation of the blade 30 and the hub 40 (the orientation of the wind turbine) in accordance with the wind direction. The nacelle 10 is an example of a structure not provided with a force generated by the drive devices. The tower 20 is an example of a structure provided with a force generated by the drive devices.

The tower 20 is embedded on the land or on the sea. The tower 20 extends upward in a vertical direction from the land or the sea. The nacelle 10 is mounted on the top end of the tower 20. The tower 20 includes a ring gear 22 used for driving the turning of the nacelle 10 in the yaw direction.

The blade 30 receives wind force and generates a rotational force. In the embodiment, three blades 30 are provided.

The hub 40 is mounted to the nacelle 10, and a plurality of blades 30 are mounted to the hub 40. The hub 40 transmits to a rotating shaft the rotational force (motive power) generated by the wind force received by the blades 30. The hub 40 transmits the rotational force based on the wind force to the nacelle 10 via the rotating shaft.

The hub 40 includes pitch drive mechanisms for generating a pitch drive force for rotating the blades 30 in the pitch direction. Each blade 30 is provided with a drive mechanism for generating a pitch drive force. The pitch drive mechanisms rotate the blades 30 in the pitch direction to control the angles of the blades 30 in accordance with the wind velocity.

In the wind power generation device 1, the motive power generated by the rotation of the blades 30 is transmitted from the hub 40 to a power generator (not shown) in the nacelle 10 and converted into an electric power by the power generator. In this way, the wind power generation device 1 performs wind power generation.

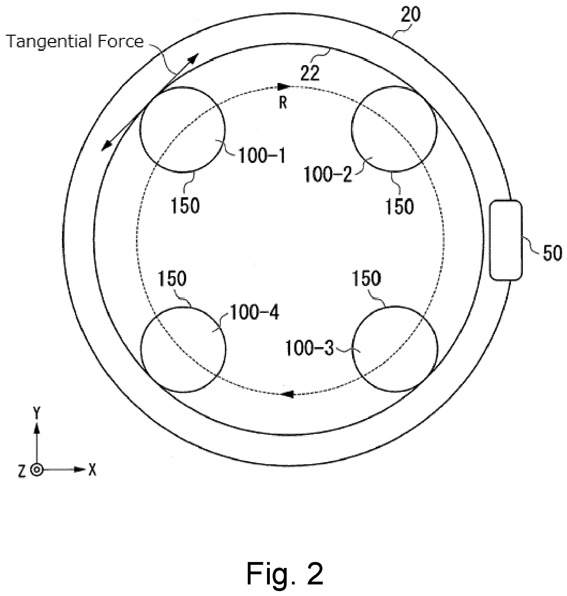

Fig. 2 is a top view showing a relationship between the tower and the yaw drive devices according to the embodiment. The yaw drive devices 100 for generating the yaw drive force are mounted to the nacelle 10. In the embodiment, four yaw drive devices 100-1, 100-2, 100-3, and 100-4 are mounted to the nacelle 10. These yaw drive devices may be hereinafter collectively referred to simply as "the yaw drive devices 100." In Fig. 2, a ring gear 22 is formed in the inner wall of the tower 20. The ring gear 22 meshes with pinion gears 150 of the yaw drive devices 100. The yaw drive devices 100 revolve by the motor drive force in the positive R direction or the negative R direction shown in Fig. 2.

With the ring gear 22 and the pinion gears 150 meshing with each other, a force such as a gust of wind applied to the nacelle 10, the tower 20 or the like generates a tangential force between the ring gear 22 and the pinion gears 150. The tangential force is a force generated in the tangential direction of the gear forming surface of the ring gear 22. The tangential force applies a torsional stress to a speed reducing unit 164 of each of the yaw drive devices 100. The tangential force applies a tensile stress and a compressive stress to a fastener in each of the yaw drive devices 100. In the embodiment, the ring gear 22 is provided in the tower 20 and the yaw drive devices 100 are fixed to the nacelle 10, but this example is not limitative. It is also possible that the nacelle 10 includes a gear portion corresponding to the ring gear 22, and the tower 20 includes yaw drive devices corresponding to the yaw drive devices 100.

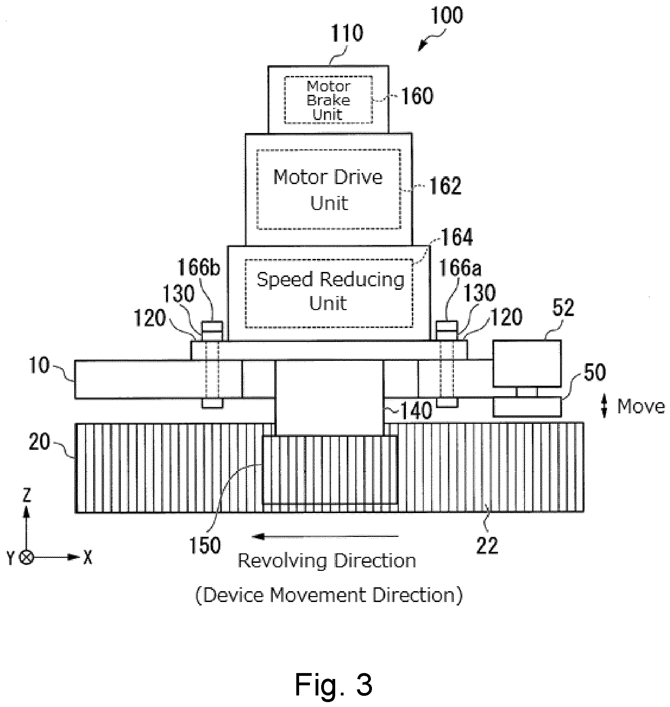

Fig. 3 shows an example of the yaw drive device according to the embodiment. The yaw drive device 100 includes, for example, a casing 110, a flange 120, fastening bolts 130, an output shaft 140, and a pinion gear 150. The flange 120 is mounted to the casing 110. The flange 120 is connected to the nacelle 10 with the fastening bolts 130. One end of the output shaft 140 is connected to the interior of the casing 110 and the flange 120, and the other end of the output shaft 140 has the pinion gear 150 provided thereon. The pinion gear 150 is positioned so as to mesh with the ring gear 22. The pinion gear 150 rotates by the drive force output from the output shaft 140 to cause the yaw drive device 100 to revolve in the revolving direction (device movement direction or negative X direction). The yaw drive device 100 in turn causes the nacelle 10 to turn relative to the tower 20. The fastening bolts 130 are an example of the fasteners. The fasteners are elements for fixing the yaw drive device 100 to the nacelle 10. The fasteners are not limited to the fastening bolts 130 but may be other known members. The output shaft 140 and the pinion gear 150 are an example of a transmission unit. The transmission unit is an element for transmitting a drive force and a braking force from the yaw drive device 100 to the tower 20. If the drive devices are fixed to the tower 20, the transmission unit is an element for transmitting the forces from the tower 20 to the nacelle 10.

The yaw drive device 100 includes a brake unit 160, a motor drive unit 162, and a speed reducing unit 164. The brake unit 160 generates a braking force applied to the output shaft 140. The motor drive unit 162 generates a drive force for the output shaft 140. The brake unit 160 generates the braking force by an electromagnetic action in accordance with a control signal provided externally. The brake unit 160 is an electromagnetic brake configured to, for example, generate no braking force when supplied with a voltage and generate the braking force when not supplied with a voltage. The brake unit 160 operates as an electromagnetic brake. The motor drive unit 162 generates the drive force by an electromagnetic action in accordance with a control signal provided externally. The speed reducing unit 164 reduces the rotation speed according to the drive force generated by the motor drive unit 162 to increase the drive torque.

Further, the yaw drive device 100 includes a strain sensor 166a and a strain sensor 166b. The strain sensors 166 are an example of the sensing circuit. The strain sensor 166a and the strain sensor 166b may be hereinafter collectively referred to simply as "the strain sensors 166." The strain sensors 166 output values (signals) based on the strain in the columnar portions of the fastening bolts 130. The strain occurring in the columnar portions of the fastening bolts 130 changes in accordance with the tangential force.

The wind power generation device 1 includes a hydraulic brake for applying a braking force to the ring gear 22. The hydraulic brake is, for example, a caliper brake mechanism. The hydraulic brake includes a hydraulic brake driving unit 52 and a friction member 50. The hydraulic brake driving unit 52 moves the friction member 50 in the Z direction shown in Fig. 3 in accordance with a control signal provided externally. The hydraulic brake driving unit 52 applies a braking force to the ring gear 22 by urging the friction member 50 against the ring gear 22. The wind power generation device 1 is preferably capable of adjusting the braking force applied to the ring gear 22.

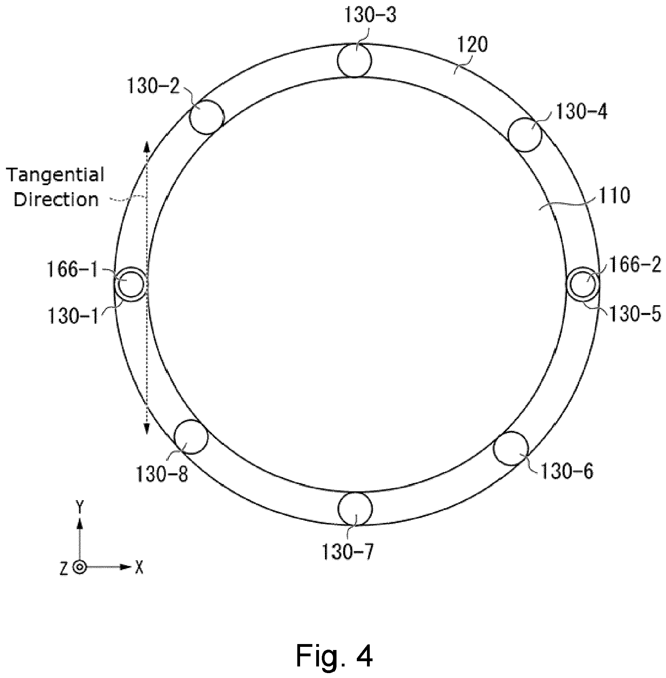

Fig. 4 is a top view showing an example of the yaw drive device according to the embodiment. In the yaw drive device 100, the casing 110 is fixed to the nacelle 10 via the flange 120 with the fastening bolts 130-1, 130-2, 130-3, 130-4, 130-5, 130-6, 130-7, 130-8. Among the fastening bolts 130, two fastening bolts 130-1, 130-5 have strain sensors 166-1, 166-2 mounted thereto, respectively. When a load is imparted to the output shaft 140, the fastening bolts 130 having the strain sensors 166 mounted thereto receive stresses in different directions. For example, when a load in the tangential direction is imparted to the output shaft 140, the fastening bolt 130-1 receives a stress in the tensile direction (the positive Z direction), and the fastening bolt 130-5 receives a stress in the compressive direction (the negative Z direction).

The fastening bolt 130-1 is an example of a first fastener for fastening the casing 110 to the nacelle 10 that moves relative to the tower 20. The fastening bolt 130-5 is an example of a second fastener for fastening the casing 110 to the nacelle 10 that moves relative to the tower 20. The second fastener is opposed to the fastening bolt 130-1 in the radial direction of the casing 110. The fastening bolt 130-1 receives a force in a first direction based on an external force imparted to the casing 110, and the fastening bolt 130-5 receives a force in a second direction based on an external force imparted to the casing 110. The combination of the fastening bolt 130-1 and the strain sensor 166-1 and the combination of the fastening bolt 130-5 and the strain sensor 166-2 are examples of a fastener with a sensing circuit.

In the embodiment, eight fastening bolts 130 are provided, but this is not limitative. It is possible to use a larger number of fastening bolts 130. Also, in the embodiment, two strain sensors 166 are provided, but this is not limitative. It is possible to use one strain sensor 166 or more than two strain sensors 166.

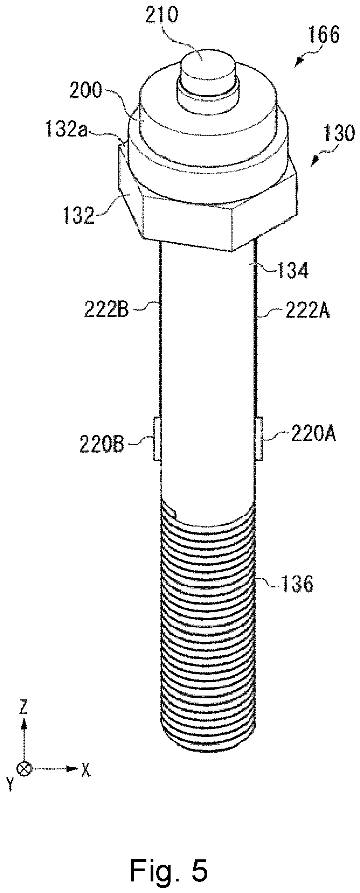

Fig. 5 is a perspective view showing an example of a fastening bolt and a strain sensor according to the embodiment. The fastening bolt 130, which is an example of the fastener, includes, for example, a head portion 132, a columnar portion 134 formed integrally with the head portion 132, and a threaded portion 136 formed integrally with the columnar portion 134. The strain sensor 166 includes, for example, a sensor casing 200 and a connector 210.

The head portion 132 has hexagonal side surfaces. The head portion 132 has a planar surface (plane) 132a on which the strain sensor 166 is mounted. The strain sensor 166 is mounted on the plane 132a. The strain sensor 166 may be attached to the plane 132a by, for example, an adhesive or a screw. The side surfaces of the head portion 132 receive a force for fastening the fastening bolt 130. The plane 132a has two holes (not shown) formed therein. The holes are positioned to contact with the columnar portion 134 in the radial direction of the head portion 132. The holes receive sensor wires 222A, 222B extending therethrough, respectively. In the embodiment, two holes are provided, but the same number of holes as the sensor wires 222 may be provided.

The diameters of the columnar portion 134 and the threaded portion 136 are smaller than that of the head portion 132. The diameter of the columnar portion 134 may be smaller than that of the threaded portion 136. The columnar portion 134 has a resistance portion 220A and the wire 222A stuck on the side surface of the columnar portion 134. The resistance portion 220A and the resistance portion 220B are strain gauges, for example. For example, the resistance portion 220A and the resistance portion 220B are opposed to each other in the radial direction of the columnar portion 134. The resistance portion 220A and the resistance portion 220B are deformed in accordance with the deformation of the columnar portion 134. The resistance portion 220A and the resistance portion 220B are examples of resistance members made of a material having an electrical resistance varying upon the deformation.

The threaded portion 136 is formed integrally with the columnar portion 134. In the side surface of the threaded portion 136, there is formed a groove for screwing to a hole (not shown) in the nacelle 10.

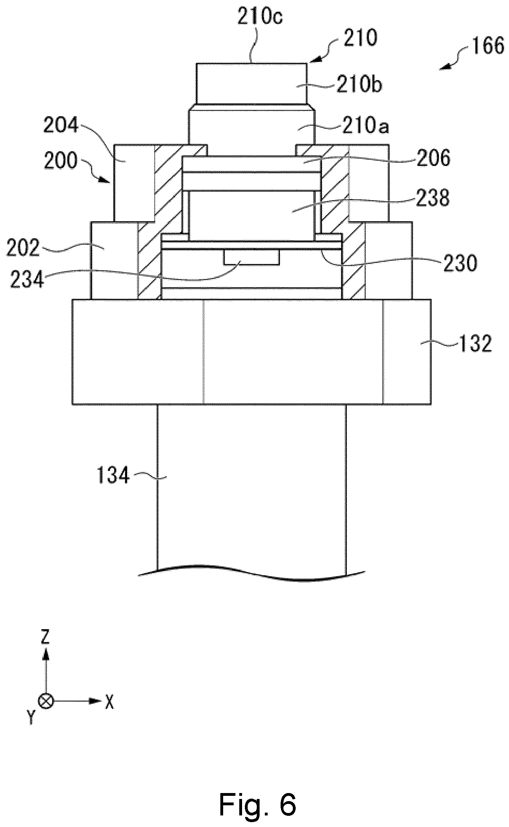

Fig. 6 shows an example of internal configuration of the strain sensor according to the embodiment. The sensor casing 200 includes, for example, a first container 202 and a second container 204. The first container 202 contains a circuit board 230. The circuit board 230 is fixed to the wall surface of the first container 202 by a screw or the like (not shown). The circuit board 230 includes a signal terminal 234, for example. The signal terminal 234 is connected with the sensor wires 222. The second container 204 contains a circuit container 238. The circuit container 238 contains a signal processing circuit (amplifier, microcomputer, and the like) that will be described later. On the circuit container 238, there is formed a threaded portion 210a that is exposed through the upper surface of the second container 204.

The connector 210 includes a tubular portion 210b and a connector terminal portion 210c, for example. The tubular portion 210b contains a signal wire (not shown) connected with the circuit board 230. The connector terminal portion 210c has such a connector shape as to connect with an external cable mechanically and electrically. The connector terminal portion 210c includes a connector terminal connected with the circuit board 230. The connector 210 is fixed to the sensor casing 200 by screwing between a threaded portion in an inner wall of a connection jig 206 and the threaded portion 210a.

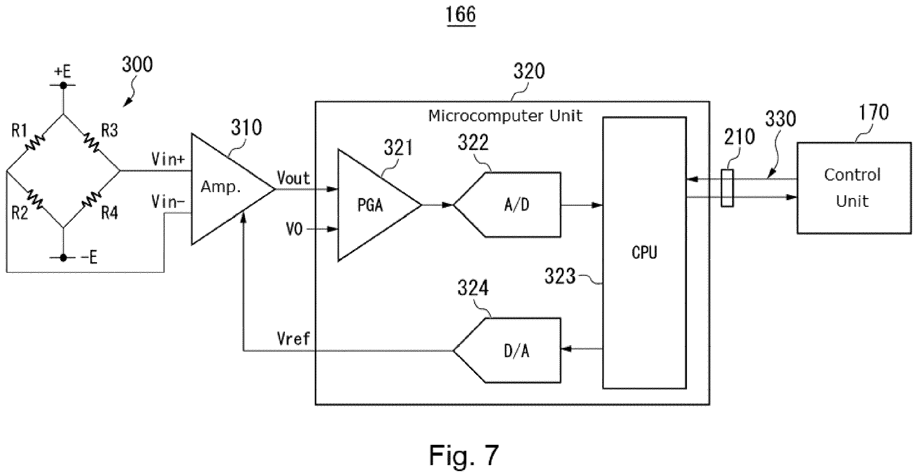

Fig. 7 shows an example of circuit configuration of the strain sensor according to the embodiment. The strain sensor 166 includes, for example, a bridge circuit 300, an amplifier 310, and a microcomputer unit 320. In the embodiment, the bridge circuit 300, the amplifier 310, and the microcomputer unit 320 are formed on the circuit board 230, for example. The microcomputer unit 320 is connected to a control unit 170 through the connector 210 and an external cable 330. The bridge circuit 300, the amplifier 310, and the microcomputer unit 320 may be formed on the head portion 132, such that the circuit board 230 can be omitted from the strain sensor 166.

The bridge circuit 300 is mounted to the head portion 132 to sense the electrical resistance of the resistance members. The electrical resistance is sensed as a value based on the strain in the columnar portion 134. The bridge circuit 300 includes four resistance elements: a resistance element R1, a resistance element R2, a resistance element R3, and a resistance element R4. At least one of the four resistance elements R1 to R4 corresponds to the resistance members constituted by the resistance portions 220A, 220B. For example, the resistance element R2 corresponds to the resistance portions 220A, 220B connected in series, and the resistance elements R1, R3, R4 correspond to a circuit portion constituted by a resistance element having a known resistance value.

The connection point between the resistance element R1 and the resistance element R3 is connected to a positive terminal (+E) of a power supply. The connection point between the resistance element R2 and the resistance element R4 is connected to a negative terminal (-E) of the power supply. The connection point between the resistance element R3 and the resistance element R4 is connected to a signal output terminal (Vin+). The connection point between the resistance element R1 and the resistance element R2 is connected to a signal output terminal (Vin-). When the fastening bolt 130 receives a stress based on a load between the ring gear 22 and the pinion gear 150, the resistance portion 220A and the resistance portion 220B are deformed by the stress based on the load. In this state, signals having the values corresponding to the load are provided between the signal output terminals.

The amplifier 310 is a signal amplifying circuit mounted to the head portion 132. The amplifier 310 is connected with the signal output terminal (Vin+) and the signal output terminal (Vin-). The amplifier 310 is provided with a reference voltage Vref from the microcomputer unit 320. The amplifier 310 amplifies signals input from the signal output terminal (Vin+) and the signal output terminal (Vin-) and outputs amplified signals (Vout).

The microcomputer unit 320 is mounted to the head portion 132. The microcomputer unit 320 includes, for example, a PGA (Programmable Gain Amplifier) 321, an A/D converter circuit 322, a CPU 323, and a D/A converter circuit 324. The PGA 321 amplifies the signals provided from the amplifier 310. The A/D converter circuit 322 converts the signal form of the signals provided from the PGA 321 from analog to digital. The CPU 323 outputs to the control unit 170 the sensor data provided from the A/D converter circuit 322. The CPU 323 sets an offset value and provides the offset value to the D/A converter circuit 324. The D/A converter circuit 324 converts the form of the offset value from digital to analog and provides the reference voltage Vref to the amplifier 310.

The microcomputer unit 320 includes the CPU 323 that operates as a communication unit to communicate serial data, but it is also possible to use other communication methods to transmit signals based on the load to the control unit 170. For example, the microcomputer unit 320 may include a wireless communication circuit for wirelessly transmitting signals based on the load to the control unit 170.

In the embodiment, the bridge circuit 300, the amplifier 310, and the microcomputer unit 320 are formed on the circuit board 230, but this is not limitative. Among the bridge circuit 300, the amplifier 310, and the microcomputer unit 320, the bridge circuit 300 may be formed on the circuit board 230. In this case, the amplifier 310 and the microcomputer unit 320 are disposed outside the strain sensor 166 and connected through the connector 210. Among the bridge circuit 300, the amplifier 310, and the microcomputer unit 320, the bridge circuit 300 and the amplifier 310 may be formed on the circuit board 230. In this case, the microcomputer unit 320 is disposed outside the strain sensor 166 and connected through the connector 210. Among the components of the microcomputer unit 320, the PGA 321, the A/D converter circuit 322, and the D/A converter circuit 324 may be formed on the circuit board 230, whereas the CPU 323 may be disposed outside the strain sensor 166 and connected through the connector 210.

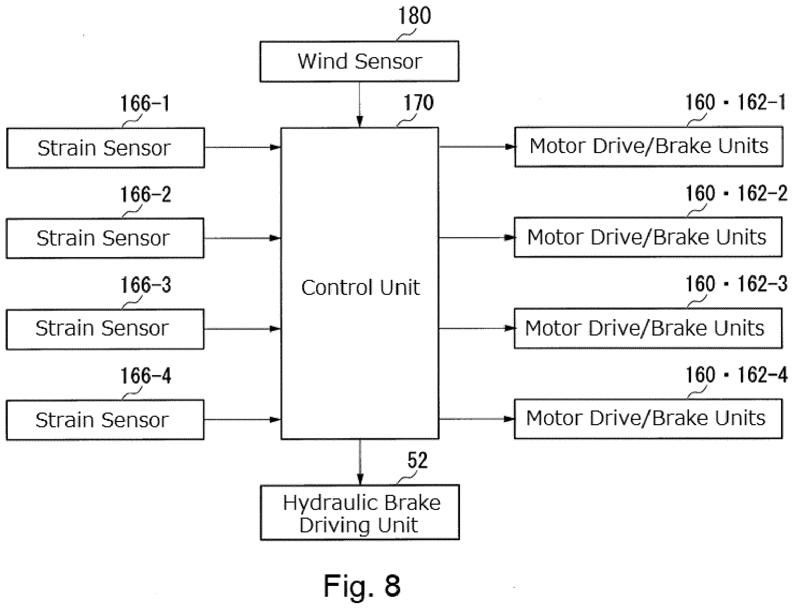

Fig. 8 is a block diagram showing an example of functionality of the wind power generation device according to the embodiment. Fig. 8 shows an example of functionality for controlling the yaw drive force in the wind power generation device 1. The wind power generation device 1 includes, for example, a control unit 170, strain sensors 166-1, 166-2, 166-3, 166-4, motor drive/brake units 160/162-1, 160/162-2, 160/162-3, 160/162-4, a hydraulic brake driving unit 52, and a wind sensor 180. The strain sensors 166-1, 166-2, 166-3, 166-4 may be hereinafter collectively referred to simply as "the strain sensors 166," the brake units 160-1, 160-2, 160-3, 160-4 may be hereinafter collectively referred to simply as "the brake units 160," and the motor drive units 162-1, 162-2, 162-3, 162-4 may be hereinafter collectively referred to simply as "the motor drive units 162,"

The strain sensor 166-1 corresponds to the strain sensor 166a and the strain sensor 166b in the yaw drive device 100-1. The strain sensor 166-2 corresponds to the strain sensor 166a and the strain sensor 166b in the yaw drive device 100-2. The strain sensor 166-3 corresponds to the strain sensor 166a and the strain sensor 166b in the yaw drive device 100-3. The strain sensor 166-4 corresponds to the strain sensor 166a and the strain sensor 166b in the yaw drive device 100-4.

The motor drive/brake unit 160/162-1 corresponds to the brake unit 160 and the motor drive unit 162 in the yaw drive device 100-1. The motor drive/brake unit 160/162-2 corresponds to the brake unit 160 and the motor drive unit 162 in the yaw drive device 100-2. The motor drive/brake unit 160/162-3 corresponds to the brake unit 160 and the motor drive unit 162 in the yaw drive device 100-3. The motor drive/brake unit 160/162-4 corresponds to the brake unit 160 and the motor drive unit 162 in the yaw drive device 100-4.

The wind sensor 180 is disposed, for example, on the top surface of the nacelle 10. The wind sensor 180 generates a signal (wind sensing signal) that indicates the wind strength and the wind direction, and provides this signal to the control unit 170.

The control unit 170 is formed of, for example, a processor such as a CPU (Central Processing Unit) executing a program stored on a program memory. The control unit 170 may alternatively be formed of hardware such as an LSI (Large Scale Integration), an ASIC (Application Specific Integrated Circuit), or a FPGA (Field-Programmable Gate Array) or formed of software and hardware cooperating with each other. The control unit 170 receives a strain sensing signal from each of the strain sensors 166-1, 166-2, 166-3, and 166-4. The control unit 170 receives a wind sensing signal from the wind sensor 180. The control unit 170 outputs control signals to the motor drive/brake units 160/162-1, 160/162-2, 160/162-3, 160/162-4, and the hydraulic brake driving unit 52 based on the strain sensing signals and the wind sensing signal.

In the fastener with a sensing circuit described above, the fastener includes a head portion 132, a columnar portion 134 formed integrally with the head portion 132, and a threaded portion 136 formed integrally with the columnar portion 134. The fastener comprises a sensing circuit (strain sensor 166) having a bridge circuit 300, the bridge circuit 300 including: a resistance portion 220 attached to the columnar portion 134; and a circuit portion mounted to the head portion 132 and connected to the resistance portion 220, the bridge circuit 300 being configured to sense electrical resistance of the resistance portion 220. With this fastener with a sensing circuit, the electrical resistance of the resistance portion 220 is sensed without using electric current in the yaw drive device 100, and therefore, a load can be sensed while the yaw drive device 100 is stopped.

With the fastener with a sensing circuit according to the embodiment, the length of wire between the resistance member 220 and the bridge circuit 300 can be reduced. Thus, the fastener with a sensing circuit makes it possible to reduce noise mixed in the signals. As a result, the fastener with a sensing circuit makes it possible to improve the accuracy in sensing the load.

In the fastener with a sensing circuit according to the embodiment, the resistance portions 220 are attached to the surface of the columnar portion 134 of the fastening bolt 130, and the circuit board 230 is mounted to the surface of the head portion 132 of the fastening bolt 130. Therefore, signals can be provided to the circuit board 230 in accordance with the deformation of the columnar portion 134. Thus, the fastener with a sensing circuit makes it possible to improve the accuracy in sensing the load between the ring gear 22 and the pinion gear 150.

Further, with the fastener with a sensing circuit according to the embodiment, for example, replacement of the strain sensor 166 requires replacement of the strain sensor 166 only, and therefore, work time and costs can be reduced.

In the fastener with a sensing circuit according to the embodiment, the electrical resistance is sensed as a value based on the strain in the columnar portion 134. With this fastener with a sensing circuit, the electrical resistance is sensed as a value based on the strain in the columnar portion 134, and therefore, a load can be sensed while the yaw drive device 100 is stopped.

In the fastener with a sensing circuit according to the embodiment, the strain sensor 166 includes an amplifier 310 mounted to the head portion 132 and configured to amplify a signal output from the bridge circuit 300. With this fastener with a sensing circuit, the signal related to electrical resistance can be amplified. In the fastener with a sensing circuit according to the embodiment, the strain sensor 166 includes an A/D converter circuit 322 mounted to the head portion 132 and configured to convert the signal amplified by the amplifier 310. With this fastener with a sensing circuit, the amplified signal related to electrical resistance can be converted. In the fastener with a sensing circuit according to the embodiment, the strain sensor 166 includes a communication unit (CPU) 323 mounted to the head portion 132 and configured to output the signal converted by the A/D converter circuit 322. With this fastener with a sensing circuit, the amplified and converted signal related to electrical resistance can be output. In the fastener with a sensing circuit according to the embodiment, the strain sensor 166 includes a connector portion 210 mounted to the head portion 132 and configured to be removably connected with an external cable. With this fastener with a sensing circuit, an external cable can be connected for outputting the amplified and converted signal related to electrical resistance.

The fastener with a sensing circuit according to the embodiment includes the amplifier 310 and thus makes it possible to improve the S/N ratio of the signal. The fastener with a sensing circuit according to the embodiment includes the A/D converter circuit 322 configured to convert the signal amplified by the amplifier 310, making it possible to output digital data and improve the S/N ratio of the signal. The fastener with a sensing circuit according to the embodiment includes the CPU 323 as a communication unit, making it possible to output the value of electrical resistance by communication processing and improve the accuracy in sensing the load. The fastener with a sensing circuit according to the embodiment includes the connector portion 210 configured to be removably connected with an external cable 330, making it possible to prevent a twist in the cable during a rotational work for mounting the fastener with a sensing circuit, simplify the work, and shorten the work time. Further, it is also possible to eliminate the risk of breakage of the external cable 330 due to a twist. Further, with the fastener with a sensing circuit according to the embodiment, the external cable 330 can be removably connected through the connector 210. This facilitates the work of fixing the external cable 330 in the nacelle 10. With the fastener with a sensing circuit according to the embodiment, the connector 210 is integrated with the circuit board 230, and therefore, the sensing circuit can be downsized.

A sensing circuit according to the embodiment comprises a bridge circuit 300, the bridge circuit 300 including: a resistance portion 220 attached to a columnar portion 134 of a fastening bolt 130, the fastening bolt 130 including a head portion 132, the columnar portion 134 formed integrally with the head portion 132, and a threaded portion 136 formed integrally with the columnar portion 134; and a circuit portion mounted to the head portion 132 and connected to the resistance portion 220, the bridge circuit 300 being configured to sense electrical resistance of the resistance portion 220. With this sensing circuit, the electrical resistance of the resistance member is sensed without using electric current in the yaw drive device 100, and therefore, a load can be sensed while the yaw drive device 100 is stopped.

A yaw drive device 100 according to the embodiment includes: a brake unit 160 for generating a braking force for stopping a nacelle 10 relative to a tower 20, the nacelle 10 being movable relative to the tower 20; and a fastening bolt 130 fixing the yaw drive device 100 including the brake unit 160 to the nacelle 10. The fastening bolt 130 includes a head portion 132, a columnar portion 134 formed integrally with the head portion 132, and a threaded portion 136 formed integrally with the columnar portion 134, and a bridge circuit 300, the bridge circuit 300 including: a resistance portion 220 attached to a columnar portion 134;and a circuit portion mounted to the head portion 132 and connected to the resistance portion 220, the bridge circuit 300 being configured to sense electrical resistance of the resistance portion 220. With this yaw drive device 100, the electrical resistance of the resistance portion 220 is sensed without using electric current in the brake unit 160 or the like, and therefore, a load can be sensed while the yaw drive device 100 is stopped.

The functions of the control unit 170 according to the embodiment described above may be implemented in a program stored on a computer-readable storage medium, and the program stored on the storage medium may be loaded onto a computer system that then executes the program for processing. The "computer system" mentioned above may include an operating system (OS) or hardware such as peripheral devices. The "computer-readable storage medium" mentioned above refers to a storage device such as a portable medium like a flexible disc, a magneto-optical disc, a ROM (Read Only Memory), a flash memory or other writable non-volatile memory, and a DVD (Digital Versatile Disc), and a hard disk built-in to the computer system.

Further, the "computer-readable storage medium" includes storage media that retain the program for some period of time, like a volatile memory (for example, DRAM (Dynamic Random Access Memory)) in an information processing device receiving the program through a network such as the Internet or a communication line such as a telephone line, and a computer system that operates as a client. The computer program mentioned above may be transmitted from a computer system that includes a storage device or the like storing the program to another computer system through a transmission medium or by a transmission wave in a transmission medium. The "transmission medium" for transmitting the program refers to a medium that operates to transmit information, like a network (communication network) such as the Internet or a communication line (communication wire) such as the telephone line. Only a part of the functions described above may be implemented in the above program. Further, the functions described above may be implemented by a combination of the above program and programs previously stored on the computer system. That is, the above program may be what is called a difference file (a difference program). The foregoing is the description of the embodiments of the present invention with reference to the drawings. Specific configurations are not limited to the above embodiments but include design modifications within the purport of the present invention.

## Claims

1. A fastener (130) with a sensing circuit (166), the fastener (130) including a head portion (132), a columnar portion (134) formed integrally with the head portion (132), and a threaded portion (136) formed integrally with the columnar portion (134), the fastener (130) comprising:
a sensing circuit (166) having a bridge circuit (300), the bridge circuit (300) including:
a resistance member (220) attached to the columnar portion (134); and
a circuit portion mounted to the head portion (132) and connected to the resistance member (220),
the bridge circuit (300) being configured to sense electrical resistance of the resistance member (220).

2. The fastener (130) with a sensing circuit (166) according to claim 1,
wherein the electrical resistance is sensed as a value based on a strain in the columnar portion (134).

3. The fastener (130) with a sensing circuit (166) according to claim 1 or 2,
wherein the sensing circuit (166) includes an amplifier (310) mounted to the head portion (132) and configured to amplify a signal output from the bridge circuit (300).

4. The fastener (130) with a sensing circuit (166) according to claim 3,
wherein the sensing circuit (166) includes a converter circuit (322) mounted to the head portion (132) and configured to convert the signal amplified by the amplifier (310).

5. The fastener (130) with a sensing circuit (166) according to claim 4,
wherein the sensing circuit (166) includes a communication unit (323) mounted to the head portion (132) and configured to output the signal converted by the converter circuit (322).

6. The fastener (130) with a sensing circuit (166) according to claim 5,
wherein the sensing circuit (166) includes a connector portion (210) mounted to the head portion (132) and configured to be removably connected with an external cable (330).

7. The fastener (130) with a sensing circuit (166) according to claim 6,
wherein the head portion (132) includes an upper surface and a lower surface, both surfaces being planar, and a hole extending from the upper surface to the lower surface,
wherein the fastener includes a side surface integrated with the lower surface and positioned to contact with an opening of the hole in a radial direction of the head portion (132), and
wherein the columnar portion (134) has a first diameter smaller than a diameter of the head portion (132).

8. A sensing circuit (166) comprising a bridge circuit (300), the bridge circuit (300) including:
a resistance member (220) attached to a columnar portion (134) of a fastener (130), the fastener (130) including a head portion (132), the columnar portion (134) formed integrally with the head portion (132), and a threaded portion (136) formed integrally with the columnar portion (134); and
a circuit portion mounted to the head portion (132) and connected to the resistance member (220),
the bridge circuit (300) being configured to sense electrical resistance of the resistance member (220).

9. A wind turbine drive device (100) comprising:
a brake unit (160) for generating a braking force for stopping a second structure (10) relative to a first structure (20), the second structure (10) being movable relative to the first structure (20); and
the fastener (130) with the sensing circuit (166) according to claim 1, the fastener (130) fixing the wind turbine drive device (100) including the brake unit (160) to the second structure (10).

10. The wind turbine drive device (100) according to claim 9, further comprising:
a drive unit (162) for generating a drive force for moving the second structure (10) relative to the first structure (20),
wherein the fastener includes a side surface and a lower surface, both surfaces being planar, and a hole extending from the upper surface to the lower surface,
wherein the columnar portion (134) includes an upper surface integrated with the lower surface and positioned to contact with an opening of the hole in a radial direction of the head portion (132), and
wherein the columnar portion (134) has a first diameter smaller than a diameter of the head portion (132),
wherein the fastener (130) fixes the wind turbine drive device (100) to the second structure (10), the wind turbine drive device (100) including the brake unit (160) and the drive unit (162), and
wherein the sensing circuit (166) includes an amplifier (310), a converter circuit (322), a communication unit (323), and a connector portion (210), the amplifier (310) being mounted to the head portion (132) and configured to amplify a signal output from the bridge circuit (300), the converter circuit (322) being mounted to the head portion (132) and configured to convert the signal amplified by the amplifier (310), the communication unit (323) being configured to output the signal converted by the converter circuit (322), the connector portion (210) being mounted to the head portion (132) and configured to be removably connected with an external cable (330).
